Europäisches Patentamt

European Patent Office

Office européen des brevets

(19)

(11) Veröffentlichungsnummer: **0 230 562**
**A1**

## (12) EUROPÄISCHE PATENTANMELDUNG

(21) Anmeldenummer: 86116677.5

(22) Anmeldetag: 01.12.86

(51) Int. Cl.4: **H01L 41/22** , C04B 35/00

(30) Priorität: 12.12.85 DE 3543962

(43) Veröffentlichungstag der Anmeldung:
05.08.87 Patentblatt 87/32

(84) Benannte Vertragsstaaten:
AT CH DE FR GB IT LI NL SE

(71) Anmelder: **Siemens Aktiengesellschaft Berlin
und München**
**Wittelsbacherplatz 2**
**D-8000 München 2(DE)**

(72) Erfinder: **Didschies, Günter**
**An der Lehmgrube 7**
**D-8500 Nürnberg 90(DE)**
Erfinder: **Grimmer, Rudolf, Dr. Dipl.-Chem.**
**Reinschartenweg 17a**
**D-8520 Erlangen(DE)**

(54) **Verfahren und Vorrichtung zum Fertigen von piezokeramischen Membranen.**

(57) Bei einem Verfahren zum Fertigen von piezokeramischen Membranen durch Sintern von Membranrohlingen werden beim Stand der Technik die Membranrohlinge aus einer wässrigen Suspension, dem sogenannten Gießschlicker, hergestellt. Der Gießschlicker wurde bisher auf eine Unterlage aufgegossen und anschließend die Membranrohlinge ausgestanzt und dem Fertigbrand zugeführt. Gemäß der Erfindung erfolgt die Herstellung der Membranrohlinge durch Siebdrucken, wozu ein speziell angepaßter Gießschlicker über eine Siebdruck-Schablone auf eine geeignete Unterlage gedruckt wird und werden nach dem Trocknen des Gießschlickers die Membranrohlinge von der Unterlage getrennt. Es hat sich gezeigt, daß mit einer zugehörigen Vorrichtung mit einer Siebdruck-Schablone (2, 20) geeigneter Stärke auch sehr dünne Membranen (11 bis 19) gefertigt werden können.

EP 0 230 562 A1

## Verfahren und Vorrichtung zum Fertigen von piezokeramischen Membranen

Die Erfindung bezieht sich auf ein Verfahren zum Fertigen von piezokeramischen Membranen durch Sintern von Membranrohlingen. Daneben bezieht sich die Erfindung auf die zugehörige Vorrichtung zur Durchführung dieses Verfahrens.

Beispielsweise für Fernsprechanlagen od.dgl. werden piezokeramische Membranen benötigt. Solche Membranen haben durchweg eine Stärke von weniger als 200 $\mu$m und bestehen speziell aus Mischungen von Bleioxiden, Titanoxiden und Zirkonoxiden, die durch einen Umsatzbrand piezokeramischen Charakter bekommen.

Bisher wurden Membranen aus Piezokeramik für obige Anwendungszwecke aus einer aufgeschlämmten, wässrigen Suspension der Oxidpulver, dem sogenannten Gießschlicker, als Folien gegossen. Diese Folien werden im Ofen getrocknet und anschließend die entsprechenden Durchmesser für die einzelnen Membranen ausgestanzt. Die Einhaltung der geforderten Foliendicke sowie deren Parallelität ist problematisch, da sie von der Viskosität des Schlickers sowie von der Ebenheit des Transportbandes abhängen. Diese Probleme sind auch mit hohem regeltechnischen Aufwand nur - schwer beherrschbar und bis heute noch nicht befriedigend gelöst.

Weiterhin werden beim sogenannten Schlickerverfahren die gesamten Folien mit zusätzlichem Zirkonoxid beschichtet, was zur Folge hat, daß der Stanzabfall sowie auch der Ausschuß nicht wieder als Rohstoff verwendbar ist. Bei den bisherigen Fertigungstechnologien konnten daher das Rohmaterial teilweise nur zu einem Drittel ausgenutzt werden.

Aufgabe der Erfindung ist es daher, ein neues Verfahren und eine zugehörige Vorrichtung anzugeben, mit denen piezokeramische Membranen wirtschaftlicher zu fertigen sind.

Gemäß der Erfindung ist die Aufgabe dadurch gelöst, daß die Herstellung der Membranrohlinge durch Siebdrucken erfolgt, wozu ein speziell angepaßter Gießschlicker über eine Siebdruck-Schablone auf eine geeignete Unterlage gedruckt wird, und daß nach dem Trocknen des Gießschlickers die Membranrohlinge von der Unterlage getrennt werden.

Überraschenderweise läßt sich die an sich bekannte Siebdrucktechnik auch zum Herstellen der Membranrohlinge verwenden, wenn durch geeignete Aufbereitung des Gießschlikkers und geeignete Unterlagen dafür Sorge getragen wird, daß keine Haftverbindung mit der Unterlage entsteht.

Das Verfahren gemäß der Erfindung bringt gegenüber dem Stand der Technik beachtliche Verbesserungen. Vorteilhaft ist insbesondere, daß dabei keinerlei Stanzabfälle entstehen. Es hat sich gezeigt, daß nunmehr auch Membranen sehr geringer Dicke, beispielsweise mit Dicken zwischen 20 und 120 $\mu$m, herstellbar sind. Dabei ist vorteilhaft, daß die Dicke der mit dem erfindungsgemäßen Verfahren hergestellten Membranen äußerst gleichmäßig ist.

Bei einer Vorrichtung zur Durchführung des erfindungsgemäßen Verfahrens mit einer Siebdruckeinrichtung weist diese ein Sieb geeigneter Stärke mit einer darin eingebrachten Rohlingsschablone auf. Dabei kann das Sieb ein Metall oder ein Kunststoff-Sieb sein. Als Unterlage für das Siebdrucken haben sich Kunststoffe, insbesondere ein Hostaphanpapier oder eine Teflonfolie bewährt. Es können auch Metallbänder verwendet werden, die mit geeigneten Trennmitteln, insbesondere Rüböl, behandelt sind.

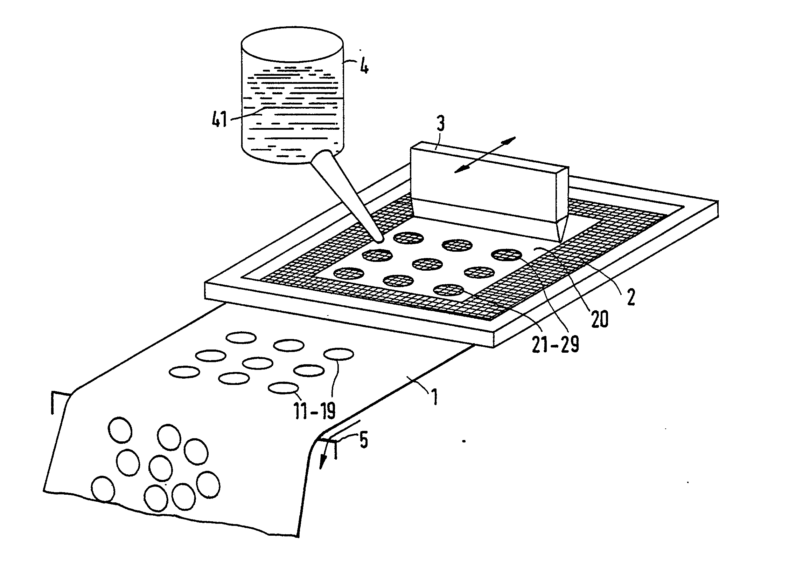

Weitere Einzelheiten und Vorteile der Erfindung ergeben sich aus der nachfolgenden Beschreibung eines Ausführungsbeispiels, wobei teilweise auf die Zeichnung Bezug genommen wird. Die einzige Figur zeigt die beim Fertigungsverfahren gemäß der Erfindung verwendeten Werkzeuge in grobschematischer Darstellung.

In der Figur ist mit 1 eine Unterlage aus Hostaphanpapier, Teflonfolie oder aus mit Rüböl behandeltem Metallband bezeichnet, auf welche ein aus Pulvermaterial hergestellter Gießschlicker aufgedruckt werden soll. Dazu ist ein Sieb 2 aus Metall oder Kunststoff vorhanden, welches die für die Membranen geforderte Stärke hat und eine Schablone 20 mit Aussparungen 21 bis 29 in parallelen Reihen aufweist, die der Größe der herzustellenden Membranrohlinge entsprechen. Der Gießschlicker wird aus einem Vorratsbehälter 4 auf das Sieb 2 aufgebracht und mittels eines Werkzeuges 3, dem sog. Rakel, derart verteilt, daß sich ein Ausfüllen der Aussparungen 21 ff. in der Siebschablone 20 ergibt.

Zum Fertigen von Membranen durch Siebdrucken wird im einzelnen folgendermaßen vorgegangen:

Als Ausgangsmaterial wurde sprühgetrocknetes, piezokeramisches Pulver einer mittleren Korngröße von 12 $\mu$m verwendet. Beispielsweise kommt als Rohmaterial ein Gemisch von Titanoxid, Bleioxid und Zirkonoxid in Frage, das durch einen Umsatzbrand die piezokeramischen Eigenschaften annimmt und die Strukturformel Pb $[Zr_x\ Ti_{x-1}]O_2$ hat. Aus dem Pulver wird durch Aufschlämmung eine wässrige Suspension erzeugt, die in der Praxis als sogenannter Gießschlicker bezeichnet wird. Ein geeigneter Gießschlicker wird für das Verfahren gemäß der Erfindung durch Versetzen mit Alkohol oder anderen wasserlöslichen organischen Substanzen hergestellt.

Ein Gießschlicker 41 wird in an sich bekannter Weise aus dem Vorratsbehälter 4 auf die Unterlage 1 gegossen, wobei aber auf der Unterlage 1 die Siebdruckschablone 2 angeordnet ist, so daß der Gießschlicker 41 lediglich in die Rohlingsaussparungen gelangt. Dies bedeutet, daß insgesamt nur soviel Material benötigt wird, wie es dem Vooumen der herzustellenden Membranrohlinge entspricht. Ein Abfall durch Stanzen od.dgl. entsteht nicht. Durch Hinund Herbewegen des Rakels 3 als Werkzeug wird der Gießschlicker unter Druck in den Aussparungen 21 bis 29 des gespannten Siebes 2 verteilt.

Anschließend wird der aufgedruckte Gießschlicker getrocknet, wobei die Unterlage 1 unter dem Schablonen sieb 2 weggezogen wird. Einzelne Membranrohlinge 11 bis 19 können nunmehr von der Unterlage 1 abgehoben werden; insbesondere können sie von der Unterlage 1 durch Ziehen derselben über eine scharfe Kante 5 getrennt werden. Die Membranrohlinge 11 bis 19 sind in diesem Zustand handhabbar und können so einzeln oder im Stapel dem Fertigbrand zugeführt werden.

Es hat sich gezeigt, daß mit dem beschriebenen Fertigungsverfahren Membranrohlinge genau vorgebbarer Dicke und guter Parallelität zu erreichen sind. Insbesondere die Herstellung von Membranen sehr geringer Dicke, beispielsweise bis zu 20 μm, wird nunmehr beherrschbar.

**Ansprüche**

1. Verfahren zum Fertigen von piezokeramischen Membranen durch Sintern von Membranrohlingen, die aus einer wässrigen Suspension des pulverförmigen Ausgangsmaterials (sog. Gieß-schlicker) hergestellt werden, **dadurch gekenn-zeichnet**, daß die Herstellung der Membranrohlinge durch Siebdrucken erfolgt, wozu ein speziell angepaßter Gießschlicker über eine Siebdruck-Schablone auf eine geeignete Unterlage gedruckt wird, und daß nach dem Trocknen des Gießschlickers die Membranrohlinge von der Unterlage getrennt werden.

2. Verfahren nach Anspruch 1, **dadurch gekennzeichnet**, daß der Gießschlicker mit wasserlöslichen organischen Substanzen versetzt ist.

3. Verfahren nach Anspruch 2, **dadurch gekennzeichnet**, daß die Substanz Alkohol ist.

4. Verfahren nach Anspruch 1, **dadurch gekennzeichnet**, daß das Trennen der Membranrohlinge von der Unterlage durch Ziehen der Unterlage über eine Kante erfolgt.

5. Vorrichtung zur Durchführung des Verfahrens nach Anspruch 1 oder einem der Ansprüche 2 bis 4 mit einer Siebdruckeinrichtung, **dadurch gekennzeichnet**, daß die Siebdruckeinrichtung ein Sieb (2) geeigneter Stärke mit darin eingebrachter Rohlingsschablone (21 bis 29) aufweist.

6. Vorrichtung nach Anspruch 5, **dadurch gekennzeichnet**, daß die Schablone in ein Metallsieb (2) als Siebdruckeinrichtung eingebracht ist.

7. Vorrichtung nach Anspruch 5, **dadurch gekennzeichnet**, daß die Schablone (20) in ein Kunststoffsieb (2) als Siebdruckeinrichtung eingebracht ist.

8. Vorrichtung nach Anspruch 5, **dadurch gekennzeichnet**, daß die Unterlage (1) aus Kunststoff besteht.

9. Vorrichtung nach Anspruch 8, **dadurch gekennzeichnet**, daß die Unterlage (1) ein Hostaphanpapier oder eine Teflonfolie ist.

10. Vorrichtung nach Anspruch 5, **dadurch gekennzeichnet**, daß die Unterlage (1) ein mit Trennmitteln behandeltes Metallband ist.

| | | |
|---|---|---|
| Europäisches Patentamt | **EUROPÄISCHER RECHERCHENBERICHT** | Nummer der Anmeldung |
| | | EP 86 11 6677 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 458 915 (BOURNS INC.)<br>* Zusammenfassung; Spalte 2, Zeilen 30-47 * | 1 | H 01 L 41/22<br>C 04 B 35/00 |
| | --- | | |
| A | US-A-3 052 949 (CLEVITE CORP.)<br>* Figur 1 * | 1 | |
| | --- | | |
| A | US-A-4 293 513 (R.C. LANGLEY et al.)<br>* Zusammenfassung * | 1 | |
| | --- | | |
| A | DE-A-3 005 057 (NARUMI CHINA CORP.) | | |
| | --- | | |
| A | EP-A-0 130 031 (MATERIALS RESEARCH CORP.) | | |
| | ----- | | **RECHERCHIERTE SACHGEBIETE (Int. Cl.4)** |
| | | | H 01 L 41<br>C 04 B 35 |

Der vorliegende Recherchenbericht wurde für alle Patentansprüche erstellt.

| Recherchenort | Abschlußdatum der Recherche | Prüfer |
|---|---|---|
| DEN HAAG | 20-03-1987 | PELSERS L. |